# EUROPEAN PATENT SPECIFICATION

(11) **EP 4 354 672 B1**
(45) Date of publication and mention of the grant of the patent: **02.12.2026**
(21) Application number: 22819467.6
(22) Date of filing: 06.06.2022
(51) Int. Cl.: H01R 13/629, H04B 1/3816, H04M 1/02

(54) **CARD TRAY ASSEMBLY AND ELECTRONIC DEVICE**
KARTENFACHANORDNUNG UND ELEKTRONISCHE VORRICHTUNG
ENSEMBLE PLATEAU DE CARTE ET DISPOSITIF ÉLECTRONIQUE

(30) Priority: 08.06.2021 CN 202110641146
(43) Date of publication of application: 17.04.2024
(73) Proprietor: Vivo Mobile Communication Co., Ltd., Dongguan, Guangdong 523863 (CN)
(72) Inventor: LI, Manlin, Dongguan, Guangdong 523863 (CN)
(74) Representative: Lavoix
(86) International application number: PCT/CN2022/097063
(87) International publication number: WO 2022/257869

(56) References cited:
- WO-A1-2015/176370
- WO-A1-2016/090784
- CN-A- 110 224 711
- CN-A- 113 346 280
- CN-U- 210 381 002
- CN-U- 210 670 044
- CN-U- 210 670 044
- CN-U- 211 320 376
- CN-U- 211 320 376
- JP-A- 2018 014 234
- US-A1- 2019 272 455

## Description

### TECHNICAL FIELD

This application relates to the field of communication technologies, and specifically, to a card tray assembly and an electronic device.

### BACKGROUND

With the development of technology, electronic devices such as mobile phones and tablet computers are having more and more functions. Consequently, the number of subscriber identity module (SIM) cards in electronic devices is also increasing, leading to more frequent insertion and removal operations on SIM cards. However, with the increasingly frequent insertion and removal operations on SIM cards, issues related to the waterproofing of card trays of the SIM cards have become increasingly prominent.

In the prior art, to prevent external liquids such water and sweat from entering the inside of an electronic device from a card tray holder of a SIM card, waterproof foam is typically provided on the inner side of the card tray holder, along with a limiting framework for limiting the waterproof foam. In this way, the card tray holder is prone to be long and occupy a large space, affecting component layout inside the electronic device.

CN 210670044U discloses a card holder and electronic equipment. CN 211320376U discloses a card holder and electronic equipment.

### SUMMARY

This application is intended to provide a card tray assembly and an electronic device, so as to solve the problem of existing card trays being long and occupying a large space.

To solve the foregoing technical problem, this application is implemented as follows.

According to a first aspect, this application discloses a card tray assembly. The card tray assembly includes a circuit board, a card tray holder, a card tray, and a waterproof cover; where
the card tray holder is connected to the circuit board, and a channel for connecting the card tray is formed between the card tray holder and the circuit board;
the card tray is disposed in the channel and able to slide along the channel to switch between a pop-up state and a mounted state; and
the waterproof cover is connected to the circuit board, and an accommodating cavity is formed between the waterproof cover and the circuit board, the accommodating cavity being opposite the channel; where
in a case that the card tray is in the mounted state, the bottom of the card tray is embedded in the accommodating cavity;
wherein an orthogonal projection of the waterproof cover onto the circuit board does not overlap with an orthogonal projection of the card tray holder onto the circuit board.

According to a second aspect, this application further discloses an electronic device. The electronic device includes a housing, a first waterproof member, and the foregoing card tray assembly; where
the card tray assembly is disposed in the housing;
the first waterproof member is disposed around two sides of the card tray holder and connected to the waterproof cover, and the first waterproof member hermetically connects the waterproof cover and the housing and hermetically connects one side of the circuit board and the housing;
an opening is provided on a side wall of the housing, and the card tray of the card tray assembly is at least partly embedded in the opening; and
a waterproof chamber is formed between the circuit board, the waterproof cover, the first waterproof member, and the housing, and the card tray is able to slide in the waterproof chamber to switch between a pop-up state and a mounted state.

In the embodiments of this application, the waterproof cover is connected to the circuit board of the card tray assembly, with an accommodating cavity formed between the waterproof cover and the circuit board, and in the case that the card tray is in the mounted state, the bottom of the card tray can be embedded in the accommodating cavity, and the waterproof cover can fit around the outside of the bottom of the card tray for waterproofing, providing a good waterproofing effect. In this way, the operation of additionally providing waterproof foam and a limiting framework at the bottom of the card tray can be avoided, and the length and occupied space of the card tray assembly can be reduced, which is conducive to the component layout inside the electronic device.

The foregoing description is merely an overview of the technical solutions of this application. For a better understanding of the technical means in this application such that they can be implemented according to the content of the specification, and to make the above and other objectives, features, and advantages of this application more obvious and easier to understand, the following describes specific embodiments of this application.

### BRIEF DESCRIPTION OF DRAWINGS

To describe the technical solutions in embodiments of this application or in the prior art more clearly, the following briefly describes the accompanying drawings required for describing the embodiments or the prior art. Apparently, the accompanying drawings in the following descriptions show some of the embodiments of this application, and persons of ordinary skill in the art may still derive other drawings from these accompanying drawings without creative efforts.
FIG. 1 is a schematic structural diagram of an electronic device according to an embodiment of this application;
FIG. 2 is a schematic structural diagram of an A-A cross section of the electronic device shown in FIG. 1;
FIG. 3 is a schematic structural diagram of a B-B cross section of the electronic device shown in FIG. 2;
FIG. 4 is a schematic structural diagram of a C-C cross section of the electronic device shown in FIG. 2;
FIG. 5 is a schematic structural diagram of a D-D cross section of the electronic device shown in FIG. 2;
FIG. 6 is a schematic diagram of a water intake path inside an electronic device according to an embodiment of this application;
FIG. 7 is a schematic structural diagram of a card tray assembly according to an embodiment of this application;
FIG. 8 is a schematic structural diagram of a waterproof cover according to an embodiment of this application;
FIG. 9 is a schematic structural diagram of the waterproof cover shown in FIG. 8 from another perspective;
FIG. 10 is a schematic structural diagram of the waterproof cover shown in FIG. 8 from still another perspective;
FIG. 11 is a schematic structural diagram of an F-F cross section of the waterproof cover shown in FIG. 10;
FIG. 12 is a schematic structural diagram of a G-G cross section of the waterproof cover shown in FIG. 10;
FIG. 13 is a schematic structural diagram of a card tray assembly using the waterproof cover shown in FIG. 8;
FIG. 14 is a schematic structural diagram of an H-H cross section of the waterproof cover shown in FIG. 13;
FIG. 15 is a schematic structural diagram of an I-I cross section of the waterproof cover shown in FIG. 13;
FIG. 16 is a schematic structural diagram of another waterproof cover according to an embodiment of this application;
FIG. 17 is a schematic structural diagram of a J-J cross section of the waterproof cover shown in FIG. 16;
FIG. 18 is a schematic structural diagram of a K-K cross section of the waterproof cover shown in FIG. 16;
FIG. 19 is a schematic structural diagram of a card tray assembly using the waterproof cover shown in FIG. 16;
FIG. 20 is a schematic structural diagram of an L-L cross section of the card tray assembly shown in FIG. 19; and
FIG. 21 is a schematic structural diagram of an M-M cross section of the card tray assembly shown in FIG. 19.

Description of reference signs:
10. circuit board, 101. solder joint, 11. card tray holder, 12. card tray, 121. first card tray, 122. second card tray, 13. waterproof cover, 131. skirt, 132. process opening, 133. cover plate, 134. connecting opening, 135. side wall, 14. housing, 141. first housing, 142. second housing, 143. opening, 15. first waterproof member, 16. second waterproof member, 17. third waterproof member, 18. fourth waterproof member, 19. battery, 20. battery cushion, S. waterproof chamber, L1. first gap, L2. side wall thickness, L3. solder joint width, L4. second gap, and S1. accommodating cavity.

### DESCRIPTION OF EMBODIMENTS

To make the objectives, technical solutions, and advantages of the embodiments of this application clearer, the following clearly describes the technical solutions in the embodiments of this application with reference to the accompanying drawings in the embodiments of this application. Apparently, the described embodiments are only some but not all of the embodiments of this application. All other embodiments obtained by persons of ordinary skill in the art based on the embodiments of this application without creative efforts shall fall within the protection scope of this application as defined by the appended claims.

A feature modified by the term "first" or "second" in the specification and claims of this application can explicitly or implicitly include one or more such features. In the description of this application, "a plurality of" means at least two unless otherwise stated. In addition, in the specification and claims, "and/or" indicates at least one of the connected objects, and the character "/" generally indicates an "or" relationship between the contextually associated objects.

In the description of this application, it should be understood that the orientations or positional relationships indicated by the terms "center", "longitudinal", "transverse", "length", "width", "thickness", "upper", "lower", "front", "rear", "left", "right", "perpendicular", "horizontal", "top", "bottom", "inside", "outside", "clockwise", "counterclockwise", "axial", "radial", "circumferential", and the like are based on the orientations or positional relationships shown in the accompanying drawings. These terms are merely for ease and brevity of description of this application rather than indicating or implying that the apparatuses or elements mentioned must have specific orientations or must be constructed or manipulated according to specific orientations, and therefore shall not be construed as any limitations on this application.

In the description of this application, it should be noted that unless otherwise specified and defined explicitly, the terms "mount", "connect", and "join" should be understood in their general senses. For example, they may refer to a fixed connection, a detachable connection, or an integral connection; a mechanical connection or an electrical connection; and a direct connection, an indirect connection via an intermediate medium, or an internal communication between two elements. Persons of ordinary skill in the art can understand specific meanings of these terms in this application based on specific situations.

An Embodiment of this application provides a card tray assembly, and the card tray assembly may be specifically used in an electronic device. The electronic device may include but is not limited to at least one of a mobile phone, a tablet computer, and a wearable device, and the electronic device may be not limited to a specific type in the embodiments of this application.

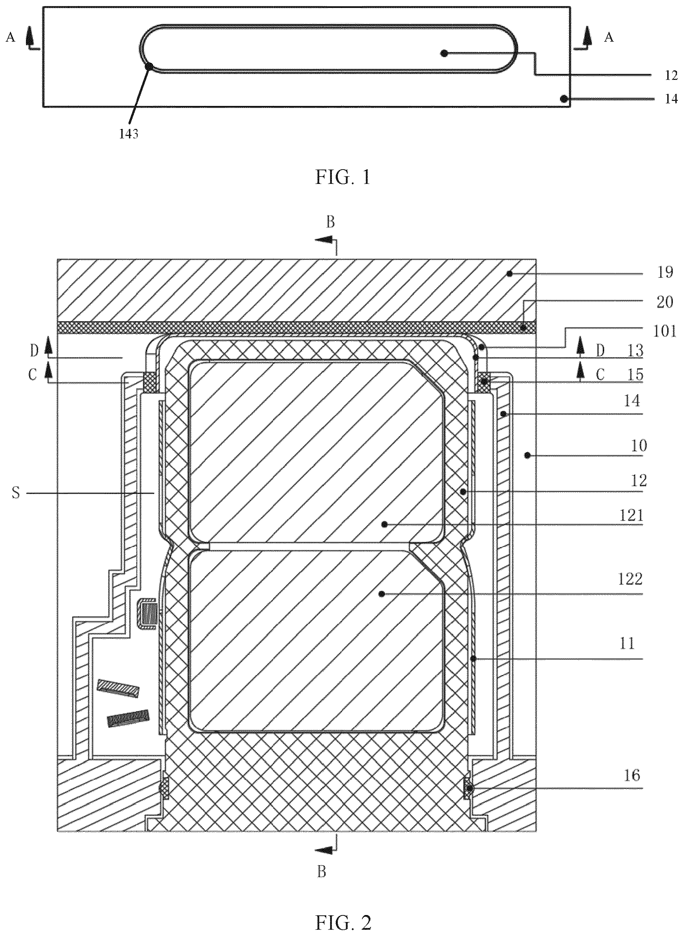

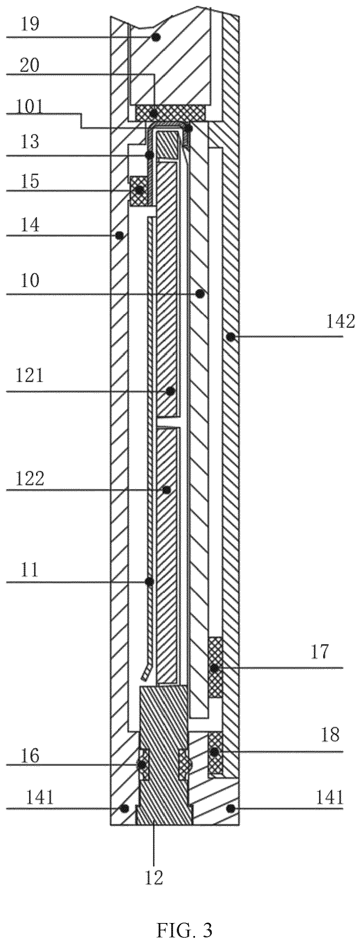

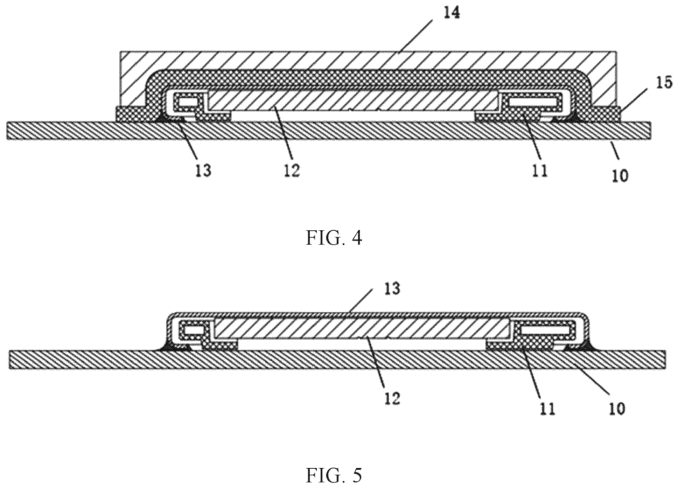

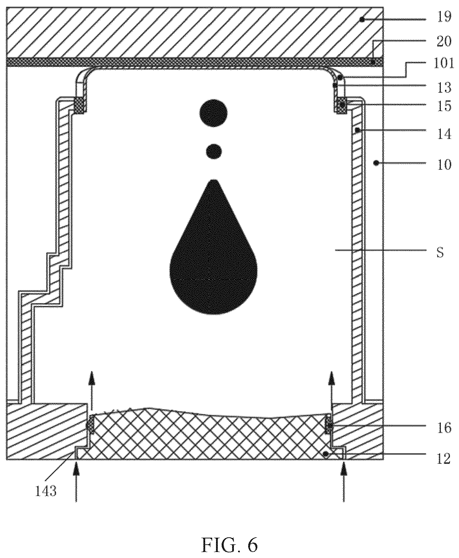

FIG. 1 is a schematic structural diagram of an electronic device according to an embodiment of this application; FIG. 2 is a schematic structural diagram of an A-A cross section of the electronic device shown in FIG. 1; FIG. 3 is a schematic structural diagram of a B-B cross section of the electronic device shown in FIG. 2; FIG. 4 is a schematic structural diagram of a C-C cross section of the electronic device shown in FIG. 2; FIG. 5 is a schematic structural diagram of a D-D cross section of the electronic device shown in FIG. 2; and FIG. 6 is a schematic diagram of a water intake path inside an electronic device according to an embodiment of this application.

As shown in FIG. 1 to FIG. 5, the electronic device may specifically include a housing 14, a first waterproof member 15, and a card tray assembly.

The card tray assembly is disposed in the housing 14, and a card tray holder 11, card tray 12, and waterproof cover 13 of the card tray assembly are all connected to a same side of a circuit board 10.

The first waterproof member 15 is disposed around two sides of the card tray holder 11 and connected to the waterproof cover 13, and one side of the first waterproof member 15 is fitted to hermetically connect the waterproof cover 13 and the housing 14 and to hermetically connect one side of the circuit board 10 and the housing 14.

An opening 143 is provided on a side wall of the housing 14, and the card tray 12 of the card tray assembly is at least partly embedded in the opening 143.

A waterproof chamber S is formed between the circuit board 10, the waterproof cover 13, the first waterproof member 15, and the housing 14, and the card tray 12 can slide in the waterproof chamber S to switch between a pop-up state and a mounted state.

In the embodiments of this application, the waterproof chamber S can be formed between the circuit board 10, the waterproof cover 13, the first waterproof member 15, and the housing 14, and the card tray 12 can slide in the waterproof chamber S to switch between a pop-up state and a mounted state. In addition, in the case that the card tray 12 is in the mounted state, the bottom of the card tray 12 can be embedded in the accommodating cavity formed by the waterproof cover 13 and the circuit board 10, and the waterproof cover 13 can fit around the outside of the bottom of the card tray 12 for waterproofing, providing a good waterproofing effect. In this way, the operation of additionally providing waterproof foam and a limiting framework at the bottom of the card tray 12 can be avoided, and the length and occupied space of the card tray assembly can be reduced, which is conducive to the component layout inside the electronic device.

Optionally, the electronic device may further include a second waterproof member 16. The second waterproof member 16 may fit around the outside of the card tray 12, and in a case that the card tray 12 is inserted into the waterproof chamber S, the second waterproof member 16 may abut against the opening 143 of the housing 14. Because the second waterproof member 16 is embedded between the opening 143 of the housing 14 and the card tray 12, the second waterproof member 16 can be used to achieve waterproofing between the card tray 12 and the opening 143 of the housing 14, and during insertion and removal of the card tray 12, the second waterproof member 16 can prevent external liquids such water and sweat from entering the inside of the electronic device from a gap between the card tray 12 and the opening 143 of the housing 14, achieving first waterproofing of the electronic device.

As shown in FIG. 6, during insertion and removal of the card tray 12, the external liquids such water and sweat can enter the inside of the electronic device from the gap between the card tray 12 and the opening 143 of the housing 14 in the directions indicated by the arrows in the figure. Because the waterproof chamber S can be formed between the circuit board 10, the waterproof cover 13, the first waterproof member 15, and the housing 14, and the bottom of the card tray 12 can be embedded in the accommodating cavity formed by the waterproof cover 13 and the circuit board 10, the waterproof cover 13 can be used to prevent the liquid in the waterproof chamber S from further flowing inward to a battery 19 of the electronic device, which avoids the battery 19 having a short circuit failure caused by water intake, achieving second waterproofing of the electronic device.

As shown in FIG. 2, in the case that the card tray 12 is in the mounted state, a distance between the bottom of the card tray 12 and the waterproof cover 13 is small, and a distance between the bottom of the card tray 12 and the battery 19 is correspondingly small. In this way, length of the entire card tray assembly in a vertical direction shown in FIG. 2 can be reduced, and the space inside the electronic device occupied by the card tray assembly can be reduced, which is conducive to the component layout inside the electronic device.

In actual use, the electronic device may further include a battery cushion 20. The battery 19 and the battery cushion 20 are both disposed in the housing 14, the battery 19 is disposed on a side of the waterproof cover 13 away from the opening 143, and the battery cushion 20 may be disposed between the waterproof cover 13 and the battery 19. The battery cushion 20 can be used to avoid damage to the battery 19 caused by rigid connection between the waterproof cover 13 and the battery 19, improving service life of the battery 19.

For example, the battery cushion 20 may be made of a flexible material such as foam and silica gel, and the battery cushion 20 may be not limited to a specific material in the embodiments of this application.

As shown in FIG. 6, a portion of the housing 14 extends into the waterproof cover 13 and is connected to the waterproof cover 13 through the first waterproof member 15, so as to better hermetically connect the housing 14 and the waterproof cover 13. In this way, even in a case that a liquid enters the waterproof chamber S, the liquid can only flow along the housing 14 into the inside of the waterproof cover 13, so that the liquid can be prevented from continuing to flow toward the battery 19 inside the electronic device. The waterproof cover 13 can be used to achieve secondary waterproofing of the electronic device, further improving waterproof performance of the electronic device.

As shown in FIG. 3, the electronic device may further include a third waterproof member 17. The third waterproof member 17 may be embedded between the other side of the circuit board 10 and the housing 14. The third waterproof member 17 can be used to prevent the external liquid from entering the inside of the electronic device from a gap between the other side of the circuit board 10 and the housing 14, which prevents the liquid from damaging the functional components on the other side of the circuit board 10 and the components inside the electronic device, further improving the waterproof performance of the electronic device.

In an optional embodiment of this application, the housing 14 may include a first housing 141 and a second housing 142 connected to each other, the other side of the first waterproof member 15 being fitted to the first housing 141; and the electronic device may further include a fourth waterproof member 18, the fourth waterproof member 18 being embedded between the first housing 141 and the second housing 142. The fourth waterproof member 18 can be used to prevent the external liquid from entering the inside of the electronic device from a gap between the first housing 141 and the second housing 142, which prevents the liquid from damaging the components inside the electronic device, further improving the waterproof performance of the electronic device.

In actual use, splitting the housing 14 into the first housing 141 and the second housing 142 that can be connected to each other not only facilitates the processing of the housing 14, but also facilitates assembling the components of the card tray assembly, the battery 19, and the like to the inside of the housing 14.

For example, the first waterproof member 15, the second waterproof member 16, the third waterproof member 17, and the fourth waterproof member 18 may be made of waterproof materials having waterproof performance and featuring flexible deformation, such as waterproof foam and waterproof silica gel, and the first waterproof member 15, the second waterproof member 16, the third waterproof member 17, and the fourth waterproof member 18 may be not limited to specific materials in the embodiments of this application.

In the embodiments of this application, the waterproof cover 13 may be made of metal such as iron and steel, and an anti-rust coating may be further provided on a surface of the waterproof cover 13. The waterproof cover 13 may be connected to the circuit board 10 by soldering, and solder joints 101 may be formed between the waterproof cover 13 and the circuit board 10. For example, the solder joint 101 may be a fillet solder joint, a spot solder joint, or the like, and the solder joint 101 may be not limited to a specific type in the embodiments of this application.

It should be noted that the accompanying drawings of the embodiments of this application show only the case in which the card tray 12 includes a first card tray 121 and a second card tray 122, that is, the case in which the card tray 12 is used to accommodate two SIM cards. However, in actual use, the card tray 12 may alternatively be designed for the case of accommodating another number of SIM cards. The number of SIM cards that can be accommodated in the card tray 12 may alternatively be one, three, five, or the like, and the number of SIM cards that can be accommodated in the card tray 12 is not specifically limited in the embodiments of this application.

In conclusion, the electronic device described in the embodiments of this application may include at least the following advantages.

In the embodiments of this application, the waterproof chamber can be formed between the circuit board, the waterproof cover, the first waterproof member, and the housing, and the card tray can slide in the waterproof chamber to switch between a pop-up state and a mounted state. In addition, in the case that the card tray is in the mounted state, the bottom of the card tray can be embedded in the accommodating cavity formed by the waterproof cover and the circuit board, and the waterproof cover can fit around the outside of the bottom of the card tray for waterproofing, providing a good waterproofing effect. In this way, the operation of additionally providing waterproof foam and a limiting framework at the bottom of the card tray can be avoided, and the length and occupied space of the card tray assembly can be reduced, which is conducive to the component layout inside the electronic device.

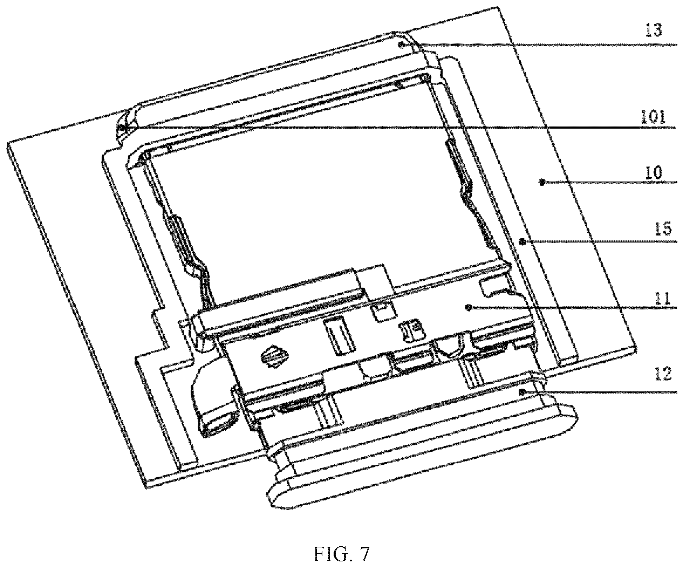

FIG. 7 is a schematic structural diagram of a card tray assembly according to an embodiment of this application. As shown in FIG. 7, the card tray assembly may specifically include a circuit board 10, a card tray holder 11, a card tray 12, and a waterproof cover 13. The card tray holder 11 is connected to the circuit board 10, and a channel for connecting the card tray 12 is formed between the card tray holder 11 and the circuit board 10. The card tray 12 is disposed in the channel and can slide along the channel to switch between a pop-up state and a mounted state. The waterproof cover 13 is connected to the circuit board 10, and an accommodating cavity is formed between the waterproof cover 13 and the circuit board 10, the accommodating cavity being opposite the channel. In a case that the card tray 12 is in the mounted state, the bottom of the card tray 12 is embedded in the accommodating cavity.

In the embodiments of this application, the waterproof cover 13 is connected to the circuit board 10 of the card tray assembly, with an accommodating cavity S1 formed between the waterproof cover 13 and the circuit board 10, and in the case that the card tray 12 is in the mounted state, the bottom of the card tray 12 can be embedded in the accommodating cavity S1, and the waterproof cover 13 can fit around the outside of the bottom of the card tray 12 for waterproofing, providing a good waterproofing effect. In this way, the operation of additionally providing waterproof foam and a limiting framework at the bottom of the card tray 12 can be avoided, and the length and occupied space of the card tray assembly can be reduced, which is conducive to the component layout inside the electronic device.

Specifically, the circuit board 10 may be a printed circuit board or a flexible printed circuit board, and the circuit board 10 may be not limited to a specific type in the embodiments of this application. The card tray holder 11 may be connected to the circuit board 10 by soldering or bonding. The card tray holder 11 can be used to support the card tray 12 to slide to achieve insertion and removal of the card tray 12.

Optionally, the waterproof cover 13 may be made of metal such as iron and steel, and an anti-rust coating may be further provided on a surface of the waterproof cover 13. The waterproof cover 13 may be connected to the circuit board 10 by soldering, so as to connect the waterproof cover 13 to the circuit board 10, and solder joints 101 may be formed between the waterproof cover 13 and the circuit board 10. For example, the solder joint 101 may be a fillet solder joint, a spot solder joint, or the like, and the solder joint 101 may be not limited to a specific type in the embodiments of this application.

As shown in FIG. 7, before the card tray assembly is assembled to the electronic device, a first waterproof member 15 may be fitted to the card tray assembly first. Specifically, the first waterproof member 15 may be fitted to both the circuit board 10 on two sides of the card tray holder 11 and the waterproof cover 13, so that the first waterproof member 15 can adequately hermetically connect the waterproof cover 13 and the housing 14 and hermetically connect the circuit board 10 and the housing 14.

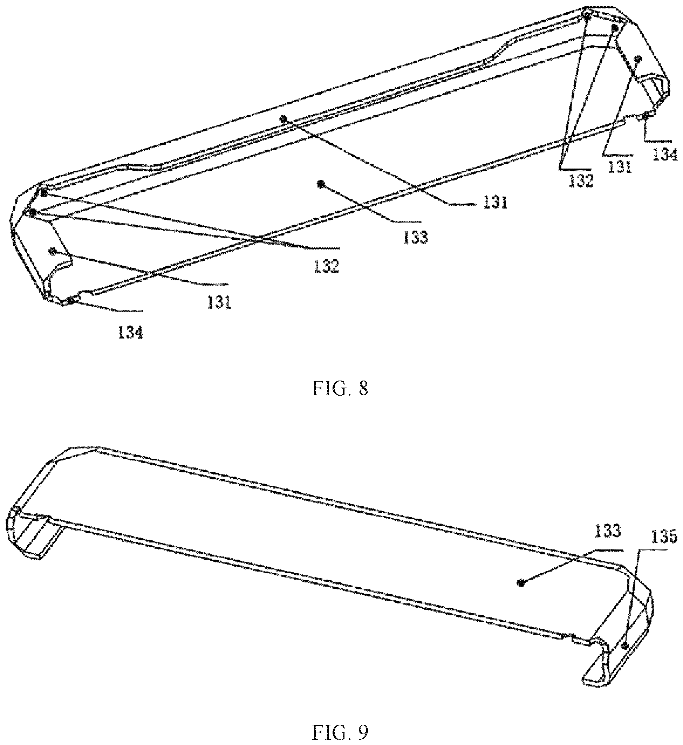

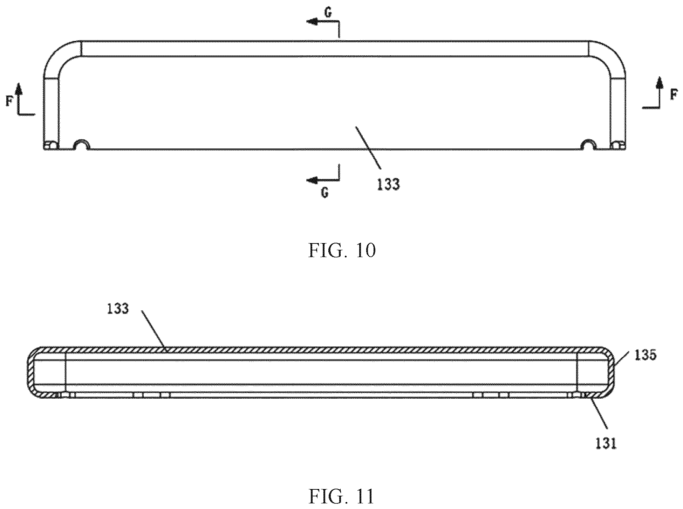

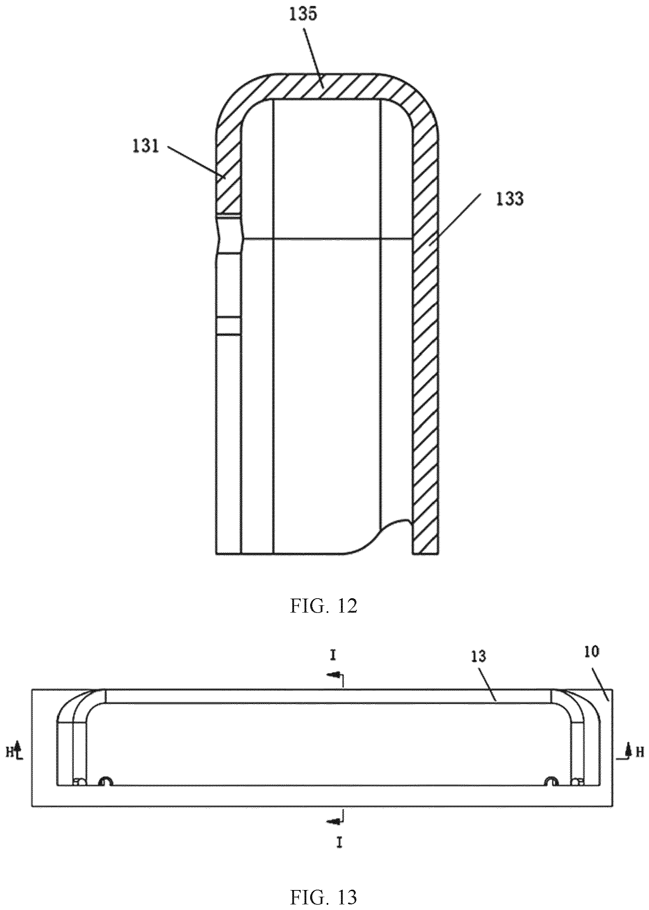

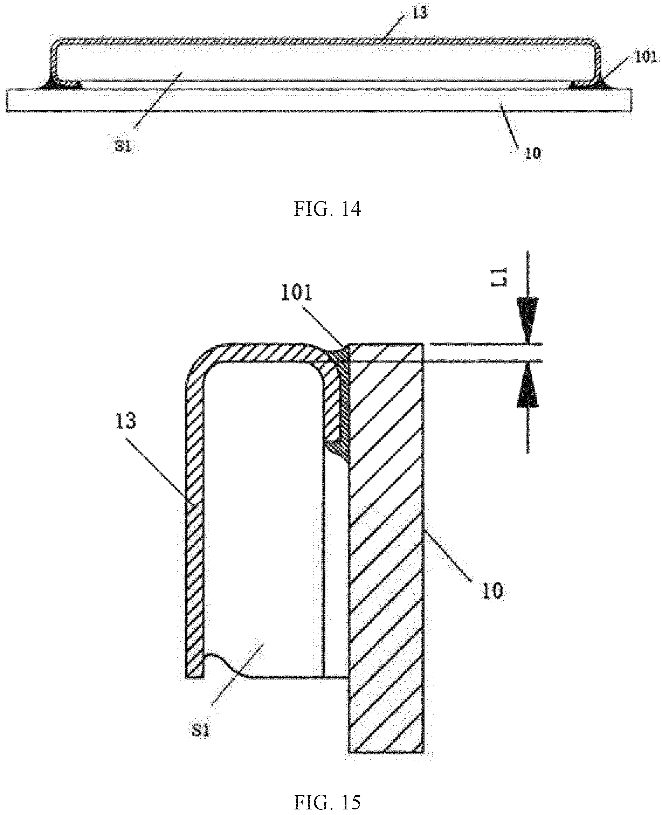

FIG. 8 is a schematic structural diagram of a waterproof cover according to an embodiment of this application; FIG. 9 is a schematic structural diagram of the waterproof cover shown in FIG. 8 from another perspective; FIG. 10 is a schematic structural diagram of the waterproof cover shown in FIG. 8 from still another perspective; FIG. 11 is a schematic structural diagram of an F-F cross section of the waterproof cover shown in FIG. 10; FIG. 12 is a schematic structural diagram of a G-G cross section of the waterproof cover shown in FIG. 10; FIG. 13 is a schematic structural diagram of a card tray assembly using the waterproof cover shown in FIG. 8; FIG. 14 is a schematic structural diagram of an H-H cross section of the waterproof cover shown in FIG. 13; and FIG. 15 is a schematic structural diagram of an I-I cross section of the waterproof cover shown in FIG. 13.

As shown in FIG. 8 to FIG. 15, the waterproof cover 13 is provided with skirts 131, and the skirts 131 can be used to be soldered to the circuit board 10. In actual use, providing the skirts 131 on the waterproof cover 13 and soldering the skirts 131 to the circuit board 10 can increase a contact area between the waterproof cover 13 and the circuit board 10, thereby improving soldering reliability between the waterproof cover 13 and the circuit board 10.

As shown in FIG. 8, the waterproof cover 13 may include a cover plate 133, three sides of the cover plate 133 may be provided with a side wall 135, and the waterproof cover 13 is soldered to the circuit board 10 through a side of the side wall 135 away from the cover plate 133, such that an accommodating cavity S1 can be formed between the cover plate 133, the side wall 135, and the circuit board 10. The opening side of the accommodating cavity S1 may be opposite the channel in which the card tray 12 slides, facilitating entering and exiting the accommodating cavity S1 by the bottom of the card tray 12.

In the embodiments of this application, skirts 131 may be further disposed on a side of the side wall 135 of the waterproof cover 13 away from the cover plate 133 to increase a contact area between the waterproof cover 13 and the circuit board 10. In specific use, the skirts 131 may be integrally formed with the waterproof cover 13 by bending or stamping to avoid the process of additionally processing the skirts 131, improving the processing efficiency of the waterproof cover 13.

Optionally, corners of the skirts 131 are provided with process openings 132, and the process openings 132 may be designed to be concave. In specific use, the material of the waterproof cover may be reduced to form the process openings 132. The process opening 132 being provided at the corner of the skirt 131 can prevent the problems of wrinkling and unevenness during stretching. In the process of soldering the skirt 131 to the circuit board 10, the process openings 132 can be filled with solder paste, so that leakage of the waterproof cover 13 can be prevented.

As shown in FIG. 15, an end face of the waterproof cover 13 may be flush with an end face of the circuit board 10, such that a first gap L1 between an outer side wall of an end portion of the waterproof cover 13 and the end face of the circuit board 10 can be minimized. In this way, the length of the card tray assembly and the space occupied by the card tray assembly can be reduced as much as possible, which is conducive to the component layout inside the electronic device.

As shown in FIG. 15, the skirt 131 on the end portion of the waterproof cover 13 may be soldered to the circuit board 10 through the solder joint 101. The solder paste in the solder joint 101 can play a good role in plugging, sealing, connecting, and fixing, so that the waterproof cover 13 and the circuit board 10 form a whole, which ensures complete hermeticity of the accommodating cavity between the waterproof cover 13 and the circuit board 10 except for the opening.

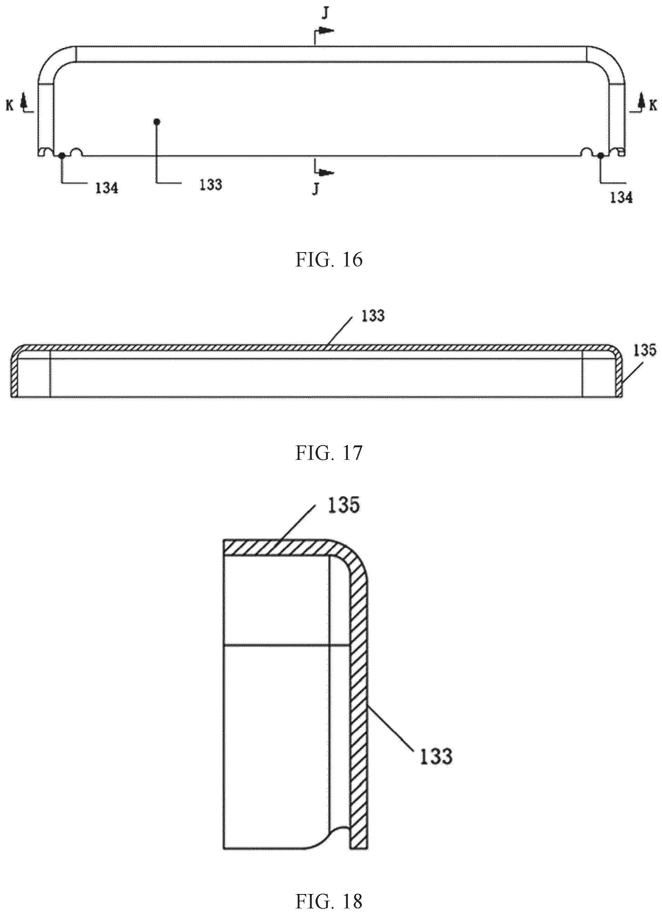

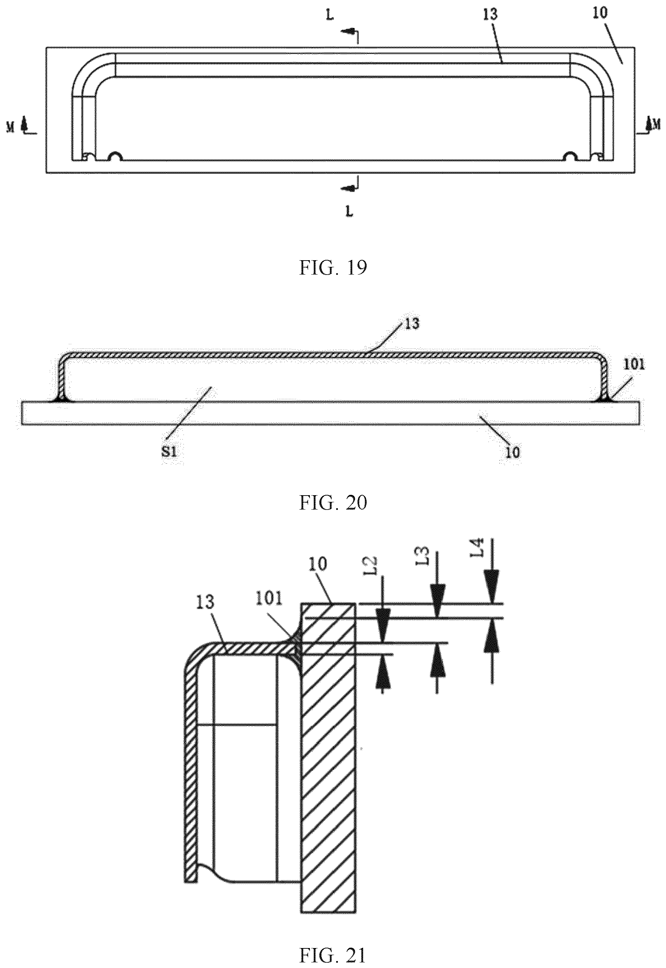

FIG. 16 is a schematic structural diagram of another waterproof cover according to an embodiment of this application; FIG. 17 is a schematic structural diagram of a J-J cross section of the waterproof cover shown in FIG. 16; FIG. 18 is a schematic structural diagram of a K-K cross section of the waterproof cover shown in FIG. 17; FIG. 19 is a schematic structural diagram of a card tray assembly using the waterproof cover shown in FIG. 16; FIG. 20 is a schematic structural diagram of an L-L cross section of the card tray assembly shown in FIG. 19; and FIG. 21 is a schematic structural diagram of an M-M cross section of the card tray assembly shown in FIG. 19.

Specifically, in the waterproof cover 13 shown in FIG. 16 to FIG. 21, the design of the skirt is eliminated relative to the waterproof cover 13 described in the foregoing embodiments. In addition, the waterproof cover 13 shown in FIG. 16 to FIG. 21 includes only a cover plate 133 and a side wall 135, and a side of the side wall 135 away from the cover plate 133 is directly soldered to the circuit board 10. In the embodiments of this application, due to the elimination of the skirt, the height of the card tray assembly can be lower, and therefore, the card tray assembly is suitable for application scenarios with low height.

As shown in FIG. 20, the side wall 135 of the waterproof cover 13 may be soldered to the circuit board 10 through solder joints 101. The solder paste in the solder joint 101 can play a good role in plugging, sealing, connecting, and fixing, so that the waterproof cover 13 and the circuit board 10 form a whole, which ensures complete hermeticity of an accommodating cavity between the waterproof cover 13 and the circuit board 10 except for an opening. In addition, due to a small contact area between the side wall 135 of the waterproof cover 13 and the circuit board 10, and to improve soldering reliability between the waterproof cover 13 and the circuit board 10, solder joints 101 may be provided on both the inner and outer sides of the side wall 135 of the waterproof cover 13.

As shown in FIG. 21, an end face of the circuit board 10 may extend beyond an end face of the waterproof cover 13, so that a preset distance is present between the end face of the circuit board 10 and the end face of the waterproof cover 13, facilitating arranging the solder joint 101.

As shown in FIG. 21, thickness of the side wall 135 of the waterproof cover 13 may be represented by a side wall thickness L2, width of the solder joint 101 may be represented by a solder joint width L3, and distance between an edge of the solder joint 101 and the end face of the circuit board 10 may be represented by a second gap L4.

In actual use, due to small side wall thickness L2 and the small contact area between the side wall 135 and the circuit board 10, and to improve the soldering reliability between the waterproof cover 13 and the circuit board 10, solder joints 101 with the solder joint width L3 need to be provided on both the inner and outer sides of the side wall 135 of the waterproof cover 13. In addition, to avoid cutting a solder pad used for arranging the solder joint 101 in the process of cutting the circuit board 10, a safety gap L4 with a certain width needs to be left between the solder joint 101 and the end face of the circuit board 10.

In conclusion, the card tray assembly described in the embodiments of this application may include at least the following advantages.

In the embodiments of this application, the waterproof cover is connected to the circuit board of the card tray assembly, with an accommodating cavity formed between the waterproof cover and the circuit board, and in the case that the card tray is in the mounted state, the bottom of the card tray can be embedded in the accommodating cavity, and the waterproof cover can fit around the outside of the bottom of the card tray for waterproofing, providing a good waterproofing effect. In this way, the operation of additionally providing waterproof foam and a limiting framework at the bottom of the card tray can be avoided, and the length and occupied space of the card tray assembly can be reduced, which is conducive to the component layout inside the electronic device.

The foregoing apparatus embodiments are merely examples. The units described as separate parts may or may not be physically separate. The parts displayed as units may or may not be physical units, meaning they may be located in one position or distributed on a plurality of network units. Some or all of the modules may be selected depending on actual requirements to achieve the objectives of the solutions of the embodiments. persons of ordinary skill in the art can understand and implement the solutions of the embodiments without creative efforts.

In this specification, reference to "an embodiment", "embodiment", or "one or more embodiments" means that specific features, structures, or characteristics described with reference to the embodiment are incorporated in at least one embodiment of this application. In addition, it should be noted that the examples of the phrase "in an embodiment" herein do not necessarily all refer to one embodiment.

A lot of specific details are described in this specification provided herein. However, it can be understood that the embodiments of this application can be implemented without such specific details. In some embodiments, in order not to obscure understanding of this specification, well-known methods, structures, and technologies are not shown in detail.

In the claims, any reference signs in brackets should not constitute any limitation on the claims. The word "comprise" does not exclude presence of elements or steps not listed in the claims. The word "a" or "an" preceding an element does not preclude presence of a plurality of such elements. This application may be implemented with the help of hardware including several different elements and with the help of an appropriately programmed computer. In the unit claims enumerating several apparatuses, several of these apparatuses may be specifically implemented by one hardware. The words "first", "second", "third", and the like do not imply any order. These words can be interpreted as names.

In conclusion, it should be noted that the foregoing embodiments are merely intended for describing the technical solutions of this application, but not for limiting this application. Although this application is described in detail with reference to the foregoing embodiments, persons of ordinary skills in the art should understand that they may still make modifications to the technical solutions described in the foregoing embodiments, without departing from the scope of the technical solutions of the embodiments of this application. The scope of the invention is defined in the appended claims.

## Claims

1. A card tray assembly, wherein
the card tray assembly comprises a circuit board (10), a card tray holder (11), a card tray (12), and a waterproof cover (13); wherein
the card tray holder (11) is connected to the circuit board (10), and a channel for connecting the card tray (12) is formed between the card tray holder (11) and the circuit board (10);
the card tray (12) is disposed in the channel and able to slide along the channel to switch between a pop-up state and a mounted state; and
the waterproof cover (13) is connected to the circuit board (10), and an accommodating cavity (S1) is formed between the waterproof cover (13) and the circuit board (10), the accommodating cavity (S1) being opposite the channel; wherein
in a case that the card tray (12) is in the mounted state, the bottom of the card tray (12) is embedded in the accommodating cavity (S1);
wherein an orthogonal projection of the waterproof cover (13) onto the circuit board (10) does not overlap with an orthogonal projection of the card tray holder (11) onto the circuit board.

2. The card tray assembly according to claim 1, wherein the waterproof cover (13) is soldered to the circuit board (10).

3. The card tray assembly according to claim 2, wherein the waterproof cover (13) is provided with skirts (131), and the skirts (131) are soldered to the circuit board (10).

4. The card tray assembly according to claim 3, wherein an end face of the waterproof cover (13) is flush with an end face of the circuit board (10).

5. The card tray assembly according to claim 3, wherein corners of the skirts (131) are provided with process openings (132).

6. The card tray assembly according to claim 2, wherein an end face of the circuit board (10) extends beyond an end face of the waterproof cover (13), so that a preset distance is present between the end face of the circuit board (10) and the end face of the waterproof cover (13).

7. The card tray assembly according to claim 1, wherein the circuit board (10) comprises at least one of a printed circuit board and a flexible printed circuit board.

8. The card tray assembly according to claim 1, wherein an anti-rust coating is further provided on a surface of the waterproof cover (13).

9. An electronic device, **characterized in that** the electronic device comprises a housing (14), a first waterproof member (15), and the card tray assembly according to any one of claims 1 to 8; wherein
the card tray assembly is disposed in the housing (14);
the first waterproof member (15) is disposed around two sides of the card tray holder (11) and connected to the waterproof cover (13), and the first waterproof member (15) hermetically connects the waterproof cover (13) and the housing (14) and hermetically connects one side of the circuit board (10) and the housing (14);
an opening (143) is provided on a side wall of the housing (14), and the card tray (12) of the card tray assembly is at least partly embedded in the opening (143); and
a waterproof chamber (S) is formed between the circuit board (10), the waterproof cover (13), the first waterproof member (15), and the housing (14), and the card tray (12) is able to slide in the waterproof chamber (S) to switch between a pop-up state and a mounted state.

10. The electronic device according to claim 9, wherein a portion of the housing (14) extends into the waterproof cover (13) and is connected to the waterproof cover (13) through the first waterproof member (15).

11. The electronic device according to claim 9, wherein the electronic device further comprises a second waterproof member (16), wherein the second waterproof member (16) fits around the outside of the card tray (12), and in a case that the card tray (12) is inserted into the waterproof chamber (S), the second waterproof member (16) abuts against the opening of the housing (14).

12. The electronic device according to claim 9, wherein the electronic device further comprises a third waterproof member (17), wherein the third waterproof member (17) is embedded between the other side of the circuit board (10) and the housing (14).

13. The electronic device according to claim 9, wherein the electronic device further comprises a battery (19) and a battery cushion (20), wherein the battery (19) and the battery cushion (20) are both disposed in the housing (14), the battery is disposed on a side of the waterproof cover (13) away from the opening, and the battery cushion (20) is disposed between the waterproof cover (13) and the battery (19).

14. The electronic device according to claim 13, wherein material of the battery cushion (20) comprises at least one of foam and silica gel.

15. The electronic device according to claim 9, wherein the housing (14) comprises a first housing (141) and a second housing (142) connected to each other, the other side of the first waterproof member (15) being fitted to the first housing (141); and
the electronic device further comprises a fourth waterproof member (18), the fourth waterproof member (18) being embedded between the first housing (141) and the second housing (142).

## Patentansprüche

1. Eine Kartenschlittenanordnung, wobei die Kartenschlittenanordnung eine
Leiterplatte (10), einen Kartenschlittenhalter (11), einen Kartenschlitten (12) und eine wasserdichte Abdeckung (13) umfasst; wobei
der Kartenschlittenhalter (11) mit der Leiterplatte (10) verbunden ist und ein Kanal zum Verbinden des Kartenschlittens (12) zwischen dem Kartenschlittenhalter (11) und der Leiterplatte (10) ausgebildet ist;
der Kartenschlitten (12) in dem Kanal angeordnet und in der Lage ist, entlang des Kanals zu gleiten, um zwischen einem ausgefahrenen Zustand und einem montierten Zustand zu wechseln; und
die wasserdichte Abdeckung (13) mit der Leiterplatte (10) verbunden ist und ein Aufnahmeraum (S1) zwischen der wasserdichten Abdeckung (13) und der Leiterplatte (10) ausgebildet ist, wobei der Aufnahmeraum (S1) dem Kanal gegenüberliegt; wobei
in einem Fall, in dem sich der Kartenschlitten (12) in dem montierten Zustand befindet, die Unterseite des Kartenschlittens (12) in den Aufnahmeraum (S1) eingebettet ist;
wobei eine orthogonale Projektion der wasserdichten Abdeckung (13) auf die Leiterplatte (10) sich nicht mit einer orthogonalen Projektion des Kartenschlittenhalters (11) auf die Leiterplatte überlappt.

2. Die Kartenschlittenanordnung nach Anspruch 1, wobei die wasserdichte Abdeckung (13) mit der Leiterplatte (10) verlötet ist.

3. Die Kartenschlittenanordnung nach Anspruch 2, wobei die wasserdichte Abdeckung (13) mit Schürzen (131) versehen ist und die Schürzen (131) mit der Leiterplatte (10) verlötet sind.

4. Die Kartenschlittenanordnung nach Anspruch 3, wobei eine Stirnfläche der wasserdichten Abdeckung (13) bündig mit einer Stirnfläche der Leiterplatte (10) ist.

5. Die Kartenschlittenanordnung nach Anspruch 3, wobei Ecken der Schürzen (131) mit Prozessöffnungen (132) versehen sind.

6. Die Kartenschlittenanordnung nach Anspruch 2, wobei eine Stirnfläche der Leiterplatte (10) über eine Stirnfläche der wasserdichten Abdeckung (13) hinausragt, sodass ein vorgegebener Abstand zwischen der Stirnfläche der Leiterplatte (10) und der Stirnfläche der wasserdichten Abdeckung (13) vorhanden ist.

7. Die Kartenschlittenanordnung nach Anspruch 1, wobei die Leiterplatte (10) mindestens eine von einer gedruckten Leiterplatte und einer flexiblen gedruckten Leiterplatte umfasst.

8. Die Kartenschlittenanordnung nach Anspruch 1, wobei auf einer Oberfläche der wasserdichten Abdeckung (13) ferner eine Rostschutzbeschichtung vorgesehen ist.

9. Ein elektronisches Gerät, **dadurch gekennzeichnet, dass** das elektronische Gerät ein Gehäuse (14), ein erstes Dichtelement (15) und die Kartenschlittenanordnung nach einem der Ansprüche 1 bis 8 umfasst; wobei
die Kartenschlittenanordnung in dem Gehäuse (14) angeordnet ist;
das erste Dichtelement (15) um zwei Seiten des Kartenschlittenhalters (11) herum angeordnet und mit der wasserdichten Abdeckung (13) verbunden ist und das erste Dichtelement (15) die wasserdichte Abdeckung (13) und das Gehäuse (14) dichtend verbindet und eine Seite der Leiterplatte (10) und das Gehäuse (14) dichtend verbindet;
eine Öffnung (143) an einer Seitenwand des Gehäuses (14) vorgesehen ist und der Kartenschlitten (12) der Kartenschlittenanordnung zumindest teilweise in die Öffnung (143) eingebettet ist; und
eine wasserdichte Kammer (S) zwischen der Leiterplatte (10), der wasserdichten Abdeckung (13), dem ersten Dichtelement (15) und dem Gehäuse (14) ausgebildet ist und der Kartenschlitten (12) in der Lage ist, in der wasserdichten Kammer (S) zu gleiten, um zwischen einem ausgefahrenen Zustand und einem montierten Zustand zu wechseln.

10. Das elektronische Gerät nach Anspruch 9, wobei sich ein Abschnitt des Gehäuses (14) in die wasserdichte Abdeckung (13) erstreckt und über das erste Dichtelement (15) mit der wasserdichten Abdeckung (13) verbunden ist.

11. Das elektronische Gerät nach Anspruch 9, wobei das elektronische Gerät ferner ein zweites Dichtelement (16) umfasst, wobei das zweite Dichtelement (16) um die Außenseite des Kartenschlittens (12) herum anliegt und in einem Fall, in dem der Kartenschlitten (12) in die wasserdichte Kammer (S) eingeführt ist, das zweite Dichtelement (16) an der Öffnung des Gehäuses (14) anliegt.

12. Das elektronische Gerät nach Anspruch 9, wobei das elektronische Gerät ferner ein drittes Dichtelement (17) umfasst, wobei das dritte Dichtelement (17) zwischen der anderen Seite der Leiterplatte (10) und dem Gehäuse (14) eingebettet ist.

13. Das elektronische Gerät nach Anspruch 9, wobei das elektronische Gerät ferner eine Batterie (19) und ein Batteriepolster (20) umfasst, wobei sowohl die Batterie (19) als auch das Batteriepolster (20) in dem Gehäuse (14) angeordnet sind, die Batterie auf einer von der Öffnung abgewandten Seite der wasserdichten Abdeckung (13) angeordnet ist und das Batteriepolster (20) zwischen der wasserdichten Abdeckung (13) und der Batterie (19) angeordnet ist.

14. Das elektronische Gerät nach Anspruch 13, wobei das Material des Batteriepolsters (20) mindestens eines von Schaumstoff und Silicagel umfasst.

15. Das elektronische Gerät nach Anspruch 9, wobei das Gehäuse (14) ein erstes Gehäuse (141) und ein zweites Gehäuse (142) umfasst, die miteinander verbunden sind, wobei die andere Seite des ersten Dichtelements (15) an dem ersten Gehäuse (141) anliegt; und
das elektronische Gerät ferner ein viertes Dichtelement (18) umfasst, wobei das vierte Dichtelement (18) zwischen dem ersten Gehäuse (141) und dem zweiten Gehäuse (142) eingebettet ist.

## Revendications

1. Un ensemble de tiroir de carte, dans lequel l'ensemble de tiroir de carte comprend une
carte de circuit (10), un support de tiroir de carte (11), un tiroir de carte (12) et un couvercle étanche (13) ; dans lequel
le support de tiroir de carte (11) est relié à la carte de circuit (10), et un canal destiné à connecter le tiroir de carte (12) est formé entre le support de tiroir de carte (11) et la carte de circuit (10) ;
le tiroir de carte (12) est disposé dans le canal et peut coulisser le long du canal pour passer d'un état sorti à un état monté et inversement ; et
le couvercle étanche (13) est relié à la carte de circuit (10), et une cavité de réception (S1) est formée entre le couvercle étanche (13) et la carte de circuit (10), la cavité de réception (S1) étant opposée au canal ; dans lequel
dans le cas où le tiroir de carte (12) est dans l'état monté, le fond du tiroir de carte (12) est inséré dans la cavité de réception (S1) ;
dans lequel une projection orthogonale du couvercle étanche (13) sur la carte de circuit (10) ne chevauche pas une projection orthogonale du support de tiroir de carte (11) sur la carte de circuit.

2. L'ensemble de tiroir de carte selon la revendication 1, dans lequel le couvercle étanche (13) est soudé à la carte de circuit (10).

3. L'ensemble de tiroir de carte selon la revendication 2, dans lequel le couvercle étanche (13) est pourvu de jupes (131), et les jupes (131) sont soudées à la carte de circuit (10).

4. L'ensemble de tiroir de carte selon la revendication 3, dans lequel une face d'extrémité du couvercle étanche (13) affleure une face d'extrémité de la carte de circuit (10).

5. L'ensemble de tiroir de carte selon la revendication 3, dans lequel des coins des jupes (131) sont pourvus d'ouvertures de procédé (132).

6. L'ensemble de tiroir de carte selon la revendication 2, dans lequel une face d'extrémité de la carte de circuit (10) s'étend au-delà d'une face d'extrémité du couvercle étanche (13), de sorte qu'une distance prédéfinie est présente entre la face d'extrémité de la carte de circuit (10) et la face d'extrémité du couvercle étanche (13).

7. L'ensemble de tiroir de carte selon la revendication 1, dans lequel la carte de circuit (10) comprend au moins l'une parmi une carte de circuit imprimé et une carte de circuit imprimé souple.

8. L'ensemble de tiroir de carte selon la revendication 1, dans lequel un revêtement antirouille est en outre prévu sur une surface du couvercle étanche (13).

9. Un dispositif électronique, **caractérisé en ce que** le dispositif électronique comprend un boîtier (14), un premier élément d'étanchéité (15) et l'ensemble de tiroir de carte selon l'une quelconque des revendications 1 à 8 ; dans lequel
l'ensemble de tiroir de carte est disposé dans le boîtier (14) ;
le premier élément d'étanchéité (15) est disposé autour de deux côtés du support de tiroir de carte (11) et relié au couvercle étanche (13), et le premier élément d'étanchéité (15) relie de manière étanche le couvercle étanche (13) et le boîtier (14) et relie de manière étanche un côté de la carte de circuit (10) et le boîtier (14) ;
une ouverture (143) est prévue sur une paroi latérale du boîtier (14), et le tiroir de carte (12) de l'ensemble de tiroir de carte est au moins partiellement inséré dans l'ouverture (143) ; et
une chambre étanche (S) est formée entre la carte de circuit (10), le couvercle étanche (13), le premier élément d'étanchéité (15) et le boîtier (14), et le tiroir de carte (12) peut coulisser dans la chambre étanche (S) pour passer d'un état sorti à un état monté et inversement.

10. Le dispositif électronique selon la revendication 9, dans lequel une partie du boîtier (14) s'étend à l'intérieur du couvercle étanche (13) et est reliée au couvercle étanche (13) par l'intermédiaire du premier élément d'étanchéité (15).

11. Le dispositif électronique selon la revendication 9, dans lequel le dispositif électronique comprend en outre un deuxième élément d'étanchéité (16), dans lequel le deuxième élément d'étanchéité (16) s'ajuste autour de l'extérieur du tiroir de carte (12), et dans le cas où le tiroir de carte (12) est inséré dans la chambre étanche (S), le deuxième élément d'étanchéité (16) vient en butée contre l'ouverture du boîtier (14).

12. Le dispositif électronique selon la revendication 9, dans lequel le dispositif électronique comprend en outre un troisième élément d'étanchéité (17), dans lequel le troisième élément d'étanchéité (17) est inséré entre l'autre côté de la carte de circuit (10) et le boîtier (14).

13. Le dispositif électronique selon la revendication 9, dans lequel le dispositif électronique comprend en outre une batterie (19) et un coussin de batterie (20), dans lequel la batterie (19) et le coussin de batterie (20) sont tous deux disposés dans le boîtier (14), la batterie est disposée sur un côté du couvercle étanche (13) éloigné de l'ouverture, et le coussin de batterie (20) est disposé entre le couvercle étanche (13) et la batterie (19).

14. Le dispositif électronique selon la revendication 13, dans lequel le matériau du coussin de batterie (20) comprend au moins l'un parmi la mousse et le gel de silice.

15. Le dispositif électronique selon la revendication 9, dans lequel le boîtier (14) comprend un premier boîtier (141) et un deuxième boîtier (142) reliés l'un à l'autre, l'autre côté du premier élément d'étanchéité (15) étant ajusté au premier boîtier (141) ; et
le dispositif électronique comprend en outre un quatrième élément d'étanchéité (18), le quatrième élément d'étanchéité (18) étant inséré entre le premier boîtier (141) et le deuxième boîtier (142).
